# EUROPEAN PATENT SPECIFICATION

(11) **EP 2 168 727 B1**
(45) Date of publication and mention of the grant of the patent: **13.07.2011**
(21) Application number: 09011925.6
(22) Date of filing: 18.09.2009
(51) Int. Cl.: B25J 15/06

(54) **Substrate conveying arm**
Substratförderarm
Bras transporteur de substrat

(30) Priority: 29.09.2008 JP 2008250046
(43) Date of publication of application: 31.03.2010
(73) Proprietor: USHIO DENKI KABUSHIKI KAISHA, Tokyo 100 (JP)
(72) Inventor: Okamoto, Hideki, Gotenba-shi Shizuoka-ken (JP); Minobe, Takeshi, Gotenba-shi Shizuoka-ken (JP); Takiura, Hirofumi, Gotenba-shi Shizuoka-ken (JP)
(74) Representative: Tomerius, Isabel

(56) References cited:
- JP-A- 7 025 459
- JP-A- 2001 180 822
- JP-A- 2001 305 562
- US-A- 3 884 368

## Description

### Background of the Invention

### Field of Invention

The present invention relates to a substrate conveying arm for conveying a printed board or a glass substrate for a liquid crystal panel while holding it by means of vacuum suction, particularly to the structure of a substrate conveying arm capable of allowing a work stage, which uses vacuum suction, to adsorb and hold it even if the substrate has a bend.

### Description of Related Art

In the process for producing printed circuit boards and liquid crystal panels, printed circuit boards and glass substrates used for liquid crystal panels can be conveyed either by a method for scooping and bringing a substrate upward with a conveying arm (e.g. JP-A-2003 131 387) or a method for adsorbing and suspending a substrate with multiple pads mounted on a conveying arm (e.g. JP-A-2001 305 562).

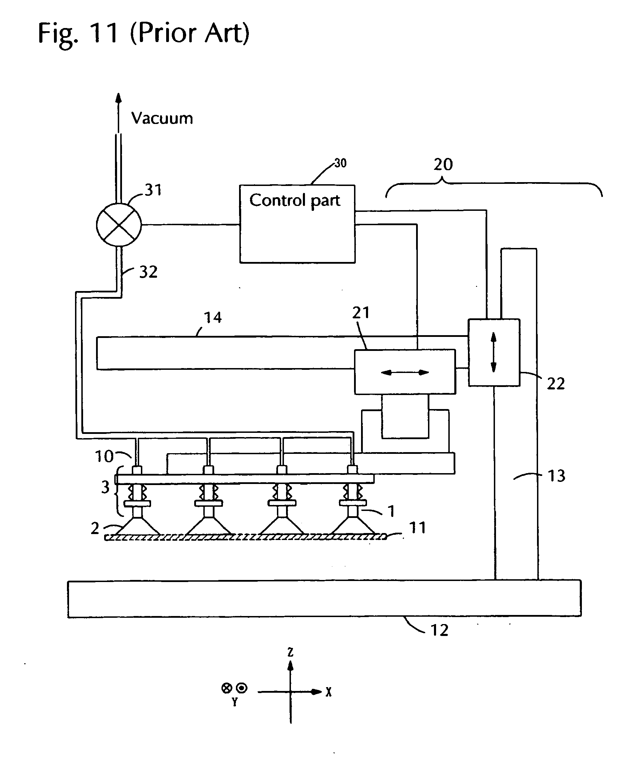

Fig. 11 is a view showing the configuration of a conveying device provided with a conveying arm for conveying a substrate by suspending it with suction pads. The conveying device in Fig. 11 is seen sideways.

The conveying arm 10 is provided with multiple suction pads 1 for holding a substrate to be conveyed 11 downward. The suction pad 1 is mainly constituted of a pad part 2 and an axis part 3. The pad part 2 is a portion that comes into contact with a substrate and is made of soft deformable resin. The axis part 3 is a portion that fixes the suction arm to the conveying arm, and extends and contracts within the range of several mm. A vacuum supply passage is formed inside the axial part.

On the surface of the substrate to be conveyed 11 is formed an area where the pad part 2 of the suction pad 1 is allowed to attach, and the suction pad 1 is mounted on the conveying arm 10 in alignment with the area. The area where the suction pad 1 is allowed to attach is often a place between two patterns of a circuit formed on the substrate 11 or a peripheral portion of the substrate where no pattern is formed.

A vacuum piping is connected to the axis part 3 of each suction pad 1, and a vacuum is supplied at the time of adsorbing and holding the substrate 11.

A conveying arm moving mechanism 20 is mounted on the conveying arm 10. The conveying arm moving mechanism 20 allows moving the substrate 11, which is being held, to a desired position. For example, in the case of an exposure device, a substrate is held by the conveying arm 10, conveyed to the position above a work stage, mounted on the work stage to be held there by vacuum suction, and then subjected to the exposure treatment.

After the exposure treatment, the substrate that was subjected to the exposure treatment is adsorbed and held by the conveying arm 10 and conveyed from the work stage to the next step.

The conveying arm moving mechanism 20 is constituted of an X direction drive part 21 and a Z direction drive part 22 that move the conveying arm in the Z direction (i.e., the vertical direction in the drawing) and the X direction (i.e., the horizontal direction in the drawing) along a Z direction guide 13 and an X direction guide 14, respectively. The Z direction guide 13 is mounted on a base plate, and the X direction guide is mounted on the Z direction drive part 22 to be moved in the Z direction.

Although there is no moving mechanism in the Y direction (i.e., the front and back direction in the drawing) shown in the drawing, there are some conveying arms provided with a mechanism that moves in the Y direction (i.e., the front and back direction in the drawing).

A control part 30 not only controls the abovementioned X direction drive part 21 and the Z direction drive part 22 to move the conveying arm to a desired position, but also controls the supply of a vacuum to the suction pad 1 of the conveying arm 10 by driving an electromagnetic valve 31 to regulate the suction, holding and release of the substrate 11 by means of the suction pad 1,

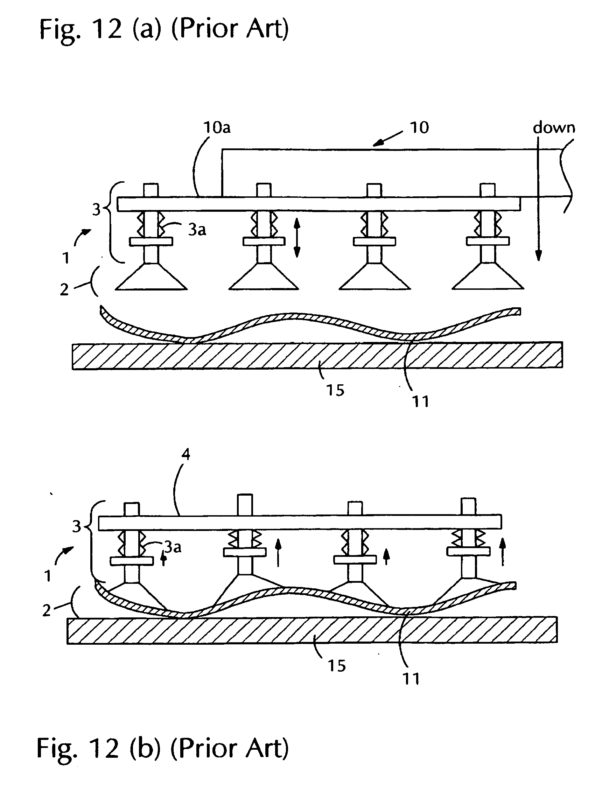

Fig. 12 shows an enlarged portion of the conveying arm 10 in Fig. 11. A description of the operation of the conveying arm 10 is given below with reference to this drawing. The vacuum piping connected to the suction pad 1 is not shown here.

As described above, the suction pad 1 is mainly formed of a pad part 2 and an axis part 3. The pad part 2 is a portion that comes into contact with a substrate. The pad part 2 is made of soft resin that is deformable to a certain degree.

The suction pad 1 is mounted on a plate 10a for the conveying arm 10 at the axis part 3. A spring 3a is mounted on the axis part 3, and therefore the suction pad 1 is movable in the vertical direction in the drawing (i.e., the Z direction) relative to the plate 10a, on which the suction pad is mounted, within the range of several mm.

The substrate 11 conveyed by the conveying arm 10 may have a bend. Particularly, a printed circuit board may have a bend as a result of the treatment processing in the previous steps. Fig. 12 shows a substrate having a bend (the bend in the drawing is exaggerated because the actual bend of the substrate is only a few mm).

A description of the operation of holding a substrate having a bend by means of a conveying arm is given below with reference to Figs. 12(a) & 12(b).

In Fig. 12(a), a vacuum is supplied to the suction pad 1 of the conveying arm 10. The conveying arm 10 moves to a location just above the stage 15 on which the substrate 11 is mounted, and then descends.

Next, as shown in Fig. 12(b), the pad part 2 of the suction pad 1 is brought into contact with the substrate 11. Although the substrate 11 is bent, the position of the axis part 3 changes vertically (i.e., in the Z direction) in a manner of agreeing with the shape of the substrate. The shape of the pad 2 also changes because it is soft. Accordingly, the substrate 11 is attached and held by the suction pad 1. Next, the conveying arm 10 ascends, and then the substrate 11 is conveyed away from the stage 15.

Even though the substrate is bent, as shown in Fig. 12(b), the conveying arm 10 is capable of connecting and holding a substrate as a result of the vertical movement of the axis part 3 in agreement with the bend and the change in the shape of the pad part 2 in the suction pad 1 and conveying it.

However, when the bent substrate 11 is mounted on a work stage with the conveying arm 10 and held there by vacuum suction, there occurs a gap between the work stage and the bent substrate 11 because the surface of the stage is flat. A vacuum used for suction supplied to the work stage leaks through the gap. As a result, the work stage cannot hold the substrate.

In order to mount the substrate 11 on a work stage with the conveying arm 10 and allow it to be held there, any bending of the substrate must be corrected and the substrate made to lie flat along the surface of the stage. However, it may not be possible for a conventional conveying arm to connect to and hold a bent substrate in a flat condition.

### Summary of the Invention

The present invention was made to solve the abovementioned problems. Thus. A primary object of the present invention is to correct a bent substrate and make it lie flat along the surface of a work stage by pressing the substrate down toward the work stage at the time of mounting the substrate on the work stage, thereby preventing any leakage of a vacuum used for suction between the substrate and the work stage and allowing the work stage to hold the substrate.

In order to solve the abovementioned problems, the present invention provides a substrate conveying arm for conveying a substrate while holding it with a suction pad on the underside thereof and mounting the substrate on a work stage used for holding it with vacuum suction, the substrate conveying arm having the following configuration.

On the side that the suction pad of the substrate conveying arm is provided, an elastic member, which is shorter than the length of the suction pad, is provided. The elastic member is made shorter than the length of the suction pad and provided above the tip end of the suction pad so that the substrate is unlikely to come off the suction pad at a time when the substrate is conveyed by the substrate conveying arm. However, when the substrate is mounted on a work stage, it is pressed down by the elastic member causing the substrate to be made flat.

It is preferred that the elastic member be mounted at a position where a peripheral portion of a substrate can be pressed toward the work stage side.

In the present invention, the configuration is such that a substrate can be pressed toward the stage side by means of an elastic member provided on the same side as that of the suction pad at a time when a conveying arm mounts the bent substrate on the work stage.

Thus, the substrate is made flat along the surface of the stage. Accordingly, a gap between the substrate and the stage disappears, which leads to the disappearance of any leakage of a vacuum supplied to the work stage for suctioning of the substrate. As a result, the work stage can hold the substrate.

### Brief Description of Drawings

Fig. 1 is a view showing the configuration of a conveying device provided with a conveying arm according to an embodiment of the present invention.

Figs. 2(a) & 2(b) are sectional views taken along line A-A line in Fig. 1.

Fig. 3 is a perspective view showing the arrangement of suction pads and flat springs attached to a conveying arm.

Figs. 4(a) & 4(b) are views for explaining a first operation of the conveying arm according to the present embodiment.

Figs. 5(a) & 5(b) are views for explaining a second operation of the conveying arm according to the present embodiment.

Figs. 6(a)-6(c) are views for explaining a third operation of the conveying arm according to the present embodiment.

Fig. 7 is a view for explaining a fourth operation of the conveying arm according to the present embodiment.

Fig. 8(a) & 8(b) are views for explaining a fifth operation of the conveying arm according to the present embodiment.

Fig. 9(a)-9(c) are views showing suction pad variations.

Fig. 10(a) & 10(b) are views showing other examples for mounting a flat spring and Fig. 10(c) shows an example of using an elastic body other than a flat spring.

Fig. 11 is a view showing the configuration of a conveying device according to the prior art provided with a conveying arm for conveying a substrate by suspending it with suction pads.

Fig. 12 is a view for explaining the operation in the prior art of holding a bent substrate with a conveying arm.

### Detailed Description of the Invention

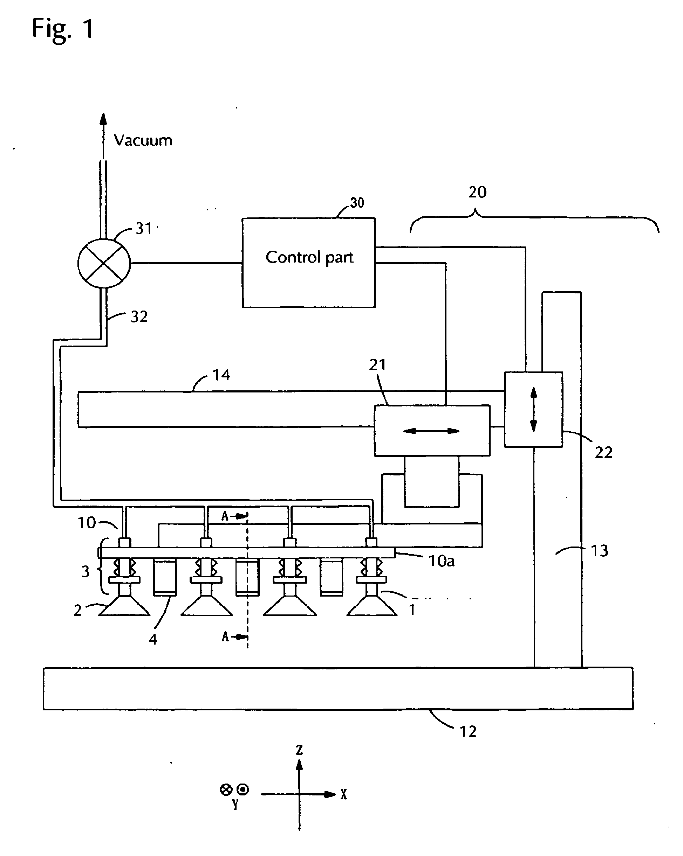

Fig. 1 is a view showing the configuration of a conveying device provided with the conveying arm according to an embodiment of the present invention. Fig. 1 differs from Fig. 11 in that multiple flat springs 4 are mounted, as elastic members, on the side of the conveying arm 10 at which the substrate 11 is held.

The other aspects are basically the same as the configuration in Fig. 11. In other words, the conveying arm 10 is provided with multiple suction pads 1 directed downward that are used for attaching the substrate 11 and made of a pad part 2 and an axis part 3. As described above, the pad part 2 is made of soft deformable resin, and a vacuum supply passage is formed inside the axis part 3. The suction pad 1 is provided at a position corresponding to a peripheral portion of the substrate, for example, as described above, or at a position that corresponds to a place between two patterns of a circuit or the like formed on the substrate 11.

The conveying arm 10 is mounted on a conveying arm moving mechanism 20. The conveying arm moving mechanism 20 allows moving of the substrate 11, which is being held, to a desired location.

As described above, the conveying arm moving mechanism 20 has an X direction drive part 21 and a Z direction drive part 22 for moving the conveying arm 10 along a Z direction guide 13 and an X direction guide 14, for example. The configuration may be such that the conveying arm can be moved in the Y direction (i.e., the front and back direction in the drawing) with a Y direction drive and guide. A control part 30 not only controls the abovementioned X direction drive part 21 and the Z direction drive part 22 to move the conveying arm to a desired location, but also controls the supply of a vacuum to the suction pad 1 of the conveying arm 10 by driving an electromagnetic valve 31 to regulate the suction, holding and release of the substrate 11 by means of the suction pad 1.

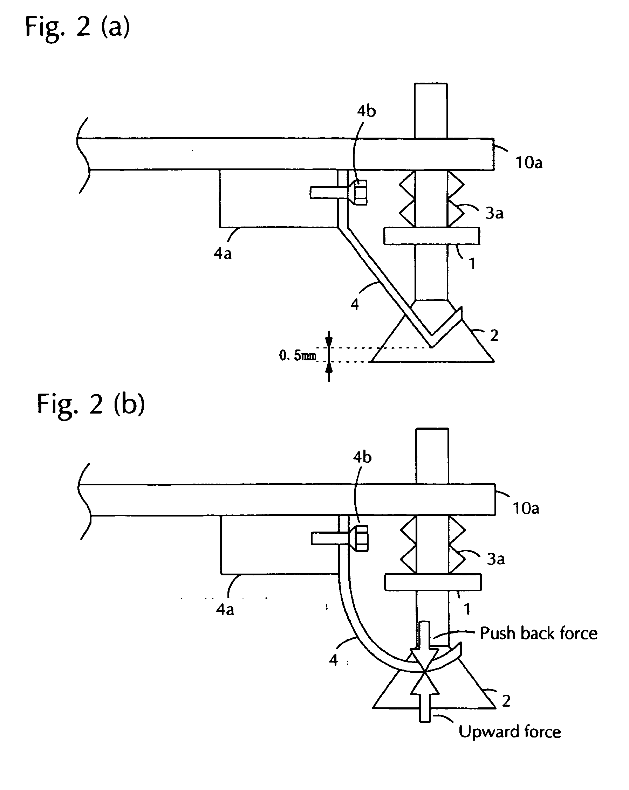

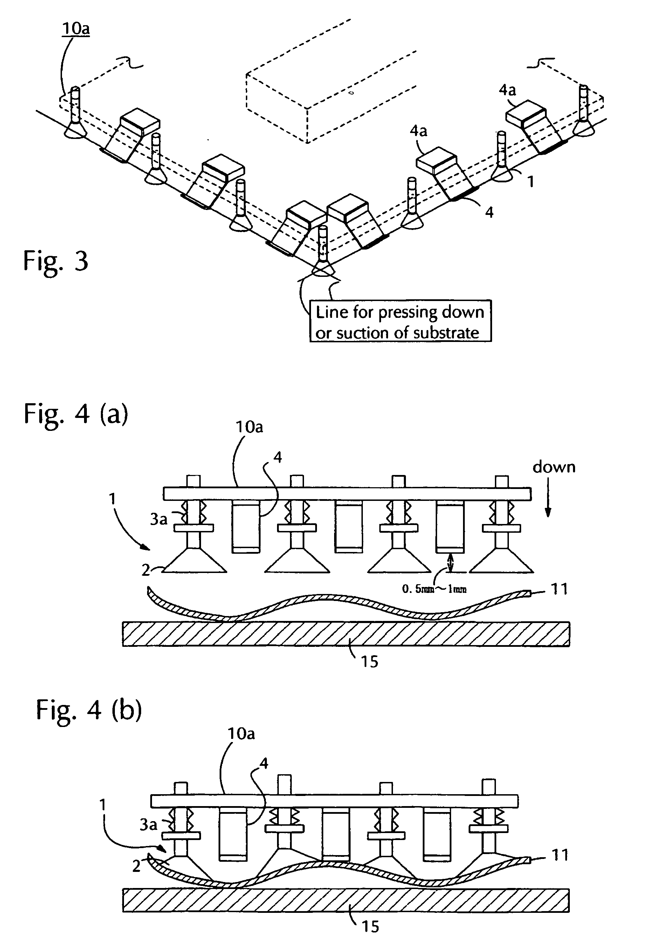

Fig 2 (a) & 2 (b) show sectional views of a portion in Fig. 1 taken by the A-A dotted line. Fig. 3 is a perspective view showing the arrangement of suction pads and flat springs attached to a conveying arm. In the drawing, a plate on which the alternating sequence of suction pads and flat springs are mounted is shown with a dotted line.

As shown in Figs. 2 & 3, each suction pad 1 is mounted on a plate 10a of the conveying arm 10 in such a way that it can suck the substrate 11 at a position that where it is allowed to come into contact therewith (i.e., a position where no pattern is formed, such as a peripheral portion).

As described in the Background of the Invention section above, the suction pad 1 is movable in the vertical direction (i.e., the Z direction) relative to the plate 10 on which it is mounted within the range of several mm. Also, the suction pad is made of soft resin that is deformable to a certain degree.

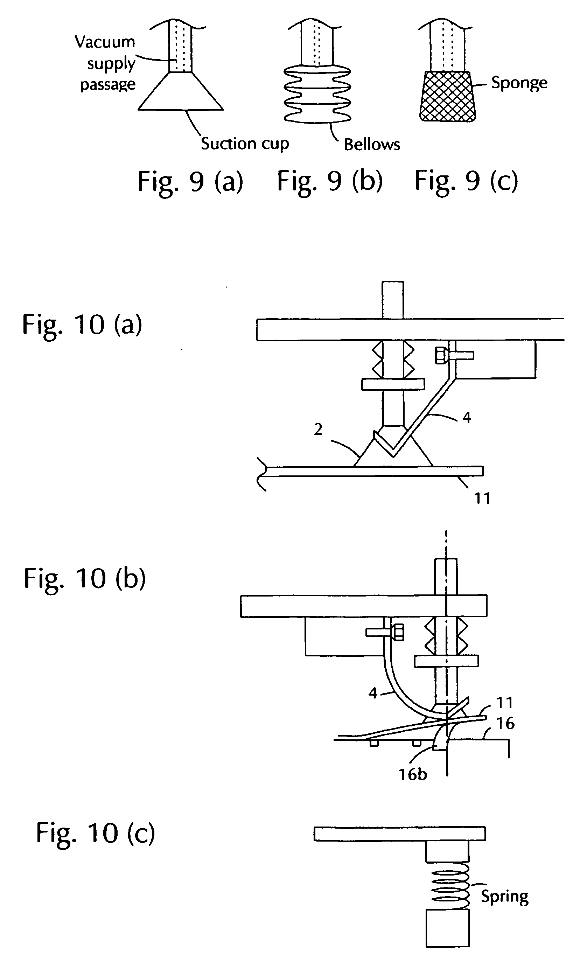

The suction pad 1 according to the present embodiment is a type as shown in Fig. 9(a). However, other shapes are also acceptable as far as they are flexible enough to adjust themselves to the deformation of a substrate to a certain degree. Other examples of suitable suction pads include one with bellows as shown in Fig. 9(b) and one formed of a sponge as shown in Fig. 9(c).

As shown in Figs. 2 & 3, the elastic member can be a flat spring 4 that is mounted on a peripheral portion of the plate 10a of the conveying arm 10. Since the flat spring 4 is brought into contact with the substrate 11 at a time when the substrate 11 is placed on the work stage as described below, the position where the flat spring 4 is provided is also one that is allowed to come into contact with the substrate 11 (i.e., a position where no pattern is formed).

One end of the flat spring 4 is fixed to a mounting block 4a with a screw 4b, for example. The block for mounting the flat spring 4a is fixed to the plate 10a for the conveying arm 10. The other end of the flat spring 4 extends to the place where the suction pads 1 are arranged and are open.

As shown in Fig. 2(b), when upward force is applied to the flat spring 4, an oppositely directed elastic force is exerted.

The flat spring 4 is shorter (in the height) than the length of the suction pad 1. The free end portion of the flat spring 4 is slightly bent back away from the tip end of the suction pad 1 to prevent the flat spring 4 striking and tearing the substrate off the suction pad 1 when the suction pad 1 attaches and conveys the substrate and the upward pressure is released.

The actual design is such that there is a gap of about 0.5 mm between the tip end of the flat spring 4 and the substrate at a time when the suction pad 1 holds the substrate.

Next, a description of the operation of the conveying arm according to the present invention is given below with reference to Figs 4-8, wherein a substrate is conveyed from a stage on which the substrate is mounted to a work stage having a vacuum suction mechanism, mounted on the work stage, and then is held there by suction. A vacuum line connected to the suction pad is not shown in these figures, but is as shown in Fig. 11.

As shown in Fig. 4(a), the conveying arm 10 is moved to the place just above the stage 15 on which the substrate 11 is mounted and then starts descending. Also, a vacuum is supplied to suction pads 1 mounted on the conveying arm 10

As shown in Fig. 4(b), the position of the suction pads 1 in the vertical direction (i.e., the Z direction) and the shape of the pad part 2 change according to the shape of the substrate 11, and then, the substrate 11 is held by the suction pads 1 under the action of the supplied vacuum.

Next, the conveying arm 10 is lifted, and the substrate 11 is conveyed out of the stage 15. The abovementioned description is the same as that in the Background of the Invention section above. At this time, flat springs 4 are shorter than the length of the suction pads 1 and are located above the tip ends of the suction pads. Therefore, the flat springs 4 have not yet been brought into use.

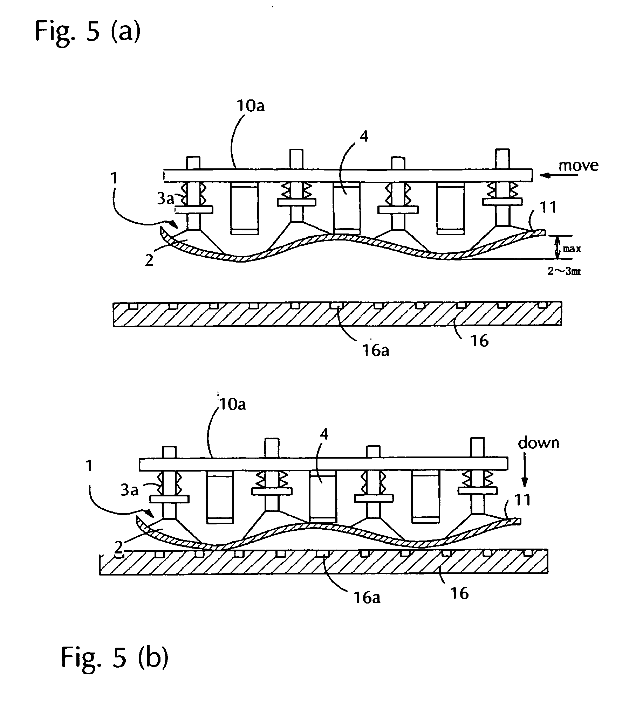

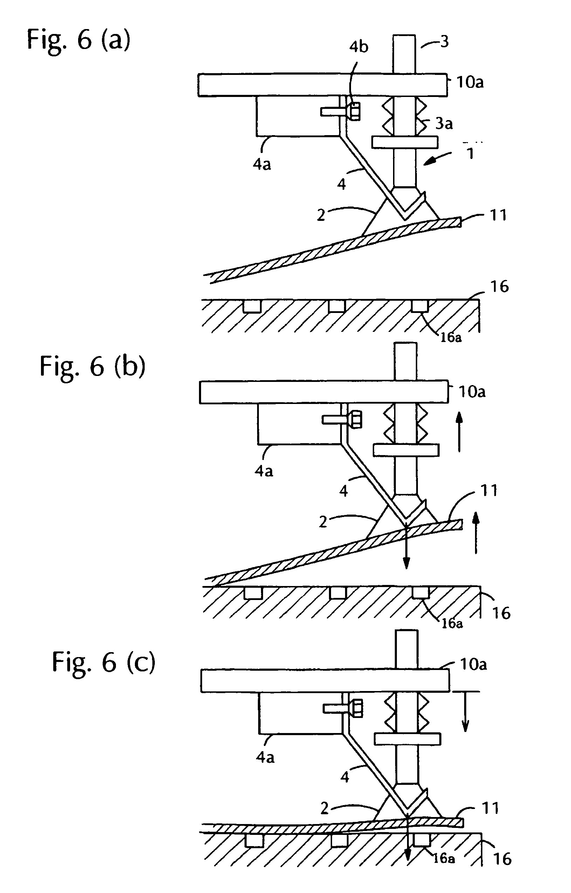

As shown in Fig. 5(a), the conveying arm 10 holding the bent substrate 11 is moved to a location above a work stage 16 where vacuum suctioning is performed to hold the substrate. Fig. 6(a) is a view of a flat spring 4 as seen sideways at this stage. The substrate 11 and the flat spring 4 have not been brought into contact with each other yet.

As shown in Fig. 5(b), the conveying arm 10 holding the bent substrate 11 starts descending, and part of the bent substrate 11 comes into contact with the surface of the work stage 16, and vacuum is supplied to vacuum suction grooves 16 formed on the surface of the work stage 16.

Fig. 6(b) is a view of a flat spring 4 as seen sideways on this stage. When part of the substrate 11 comes into contact with the surface of the work stage 16, the peripheral portion of the substrate 11 on the upwardly bent side (i.e., the side that is away from the work stage) is brought upward by reaction.

The suction pad 1 moves toward the side of the plate 10a, and then the peripheral portion of the substrate 11 on the upwardly bent side comes into contact with the flat spring 4. Although it tries to push the flat spring 4 upward, the substrate 11 is instead pressed down toward the work stage 16 by the elastic force of the flat spring 4.

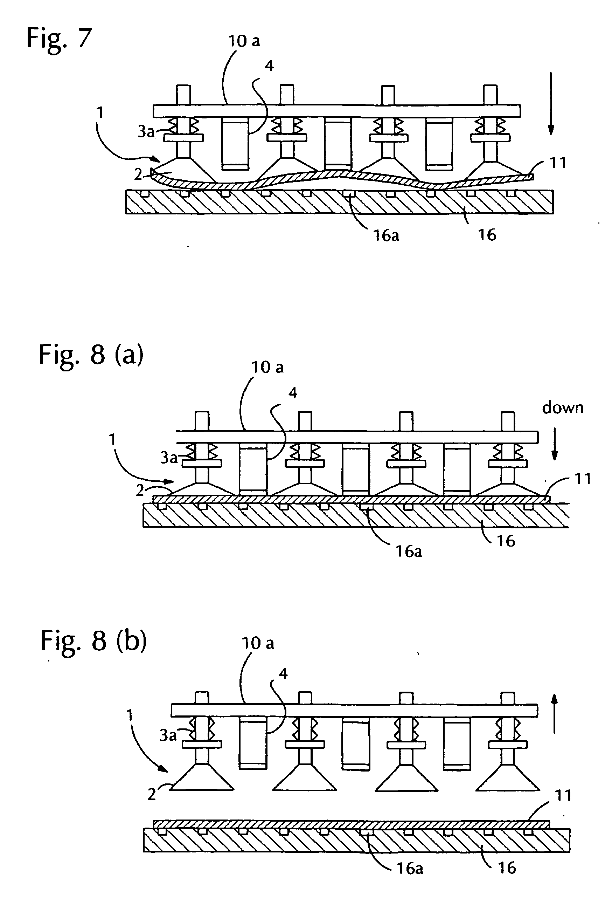

As shown in Fig. 7, the conveying arm 10 is further brought downward. As shown in Fig. 6(c), the flat spring 4 further presses the peripheral portion of the substrate on the upwardly bent side down toward the work stage 16. The peripheral portion of the substrate 11 is corrected to be made flat along the surface of the work stage 16.

As shown in Fig. 8(a), the conveying arm 10 is brought further downward. The peripheral portion of the substrate 11 is pressed down toward the work stage 16 by the flat springs 4 and caused to be made flat along the surface of the work stage 16. The gap between the work stage 16 and the substrate 11 disappears, which leads to the disappearance of any leakage of a vacuum supplied to vacuum suction grooves 16a. Even if there is a bend at the central portion of the substrate 11, and therefore, there is a space between the central portion of the substrate 11 and the work stage 16, this space is also pulled and a vacuum is created over time because there is no leakage of a vacuum from the peripheral portions of the substrate. As a result, the substrate 11 is drawn down and held against the work stage 16.

Next, as shown in Fig. 8(b), the supply of a vacuum to the suction pads 1 is stopped. The conveying arm 10 releases its hold on the substrate 11 and moves upward. The structure may be such that air can be supplied to the vacuum line to create a back pressure at the time of releasing the holding of the substrate 11.

In the abovementioned embodiment, as shown in Fig. 2, for example, the flat spring 4 used for pressing down the substrate 11 is mounted in such a manner that the substrate 11 is pressed outwardly by the spring 4 which extends outward from the mounting block which is located inward of the suction pad. However, the spring 4 may also be mounted in such a manner that the substrate is pressed inwardly by the spring 4 extending inward from the mounting block which is located outward of the suction pad as shown in Fig. 10(a).

Moreover, there may be a work stage 16 used for holding the substrate 11, wherein a lip seal is mounted on the peripheral portion thereof so that the bent substrate can easily be held by vacuum. In the case of a work stage provided with such a lip seal, the position of the substrate 11 to be pressed down by the flat spring 4 (an elastic member) is preferably in agreement with the position where the lip seal 16a is provided, as shown in Fig. 10(b). In this manner, it is easier to prevent a vacuum from leaking from a peripheral portion of the substrate 11.

Furthermore, as shown in Figs. 1 & 3 and the like, the suction pads 1 and the flat springs 4 (elastic members) are provided in an alternating sequence so that the number of the suction pads 1 is nearly the same as the number of the flat springs 4. However, the number of the flat springs 4 (elastic members) may be decreased or increased. The level of the force used for correcting a bend (i.e., the force used for pressing down the bent substrate toward the work stage) varies depending on the thickness of the substrate 11 and the difference in material properties. The position and number of the flat springs 4 (elastic members) provided for the conveying arm 10 can optionally be designed depending on the type of substrate to be conveyed.

In the abovementioned embodiment, a flat spring is used as an elastic member. However, the elastic member is not limited to a flat spring. A coil spring may be used as shown in Fig. 10(c). In fact, any other type of elastic member, e.g., a block of elastic material, can be used so long as it can produce a force sufficient to press the peripheral portion of a bent substrate down toward a work stage.

In this case, again, the tip of an elastic member must slightly be above the tip end of a suction pad in the state that no substrate is held so that the elastic member will not push the substrate off the suction pad during conveying of the substrate.

## Claims

1. A substrate conveying device for conveying a substrate, comprising:
a conveying arm (10),
a plurality of suction pads (1) mounted on the underside of the conveying arm for holding a substrate with vacuum,
and a plurality of elastic members (4) which are shorter in length than the suction pads mounted on the underside of the conveying arm so that free ends of the elastic members are located above tip ends of the suction pads so as to not engage the substrate held by the suction pads during conveyance of the substrate.

2. Substrate conveying device according to claim 1, wherein the elastic members are flat springs.

3. Substrate conveying device according to claim 1, wherein the elastic members are coil springs.

4. Substrate conveying device according to any one of claims 1 to 3, wherein the elastic members are arranged between neighboring suction pads.

5. Substrate conveying device according to any one of claims 1 to 4, wherein the elastic members are mounted on mounting blocks attached to the underside of the conveying arm.

6. Substrate conveying device according to any one of claims 1 to 5, wherein the elastic members are arranged so as to press onto a surface of the substrate at a time when the substrate is placed on the work stage.

7. Substrate conveying device according to claim 6, wherein the elastic members are arranged so as to press onto a peripheral portion of the substrate at a time when the substrate is placed on the work stage.

## Patentansprüche

1. Substrattransportvorrichtung zum Transportieren eines Substrats, umfassend:
einen Transportarm (10),
eine Mehrzahl an Saugnäpfen (1), die an der Unterseite des Transportarms befestigt sind und dem Festhalten eines Substrats mittels eines Vakuums dienen,
und eine Mehrzahl elastischer Elemente (4), die kürzer sind als die an der Unterseite des Transportarms montierten Saugnäpfe, sodass die freien Enden der elastischen Elemente über den Enden der Saugnäpfe angeordnet sind, sodass sie während des Transports des Substrats keine Verbindung mit dem von den Saugnäpfen gehaltenen Substrat eingehen.

2. Substrattransportvorrichtung gemäß Anspruch 1, wobei die elastischen Elemente Flachfedern sind.

3. Substrattransportvorrichtung gemäß Anspruch 1, wobei die elastischen Elemente Spiralfedern sind.

4. Substrattransportvorrichtung gemäß einem der Ansprüche 1 bis 3, wobei die elastischen Elemente zwischen benachbarten Saugnäpfen angeordnet sind.

5. Substrattransportvorrichtung gemäß einem der Ansprüche 1 bis 4, wobei die elastischen Elemente an Montageblöcken montiert sind, die an der Unterseite des Transportarms befestigt sind.

6. Substrattransportvorrichtung gemäß einem der Ansprüche 1 bis 5, wobei die elastischen Elemente so angeordnet sind, dass sie zu einem Zeitpunkt auf eine Oberfläche des Substrats drücken, wenn das Substrat auf der Arbeitsbühne platziert ist.

7. Substrattransportvorrichtung gemäß Anspruch 6, wobei die elastischen Elemente so angeordnet sind, dass sie zu einem Zeitpunkt auf einen außenumfänglichen Abschnitt des Substrats drücken, wenn das Substrat auf der Arbeitsbühne platziert ist.

## Revendications

1. Dispositif d'acheminement de substrat pour acheminer un substrat, comprenant:
un bras d'acheminement (10),
une pluralité de ventouses (1) montées sur la face inférieure du bras d'acheminement pour maintenir un substrat par aspiration,
et une pluralité d'éléments élastiques (4) qui sont plus courts en longueur que les ventouses montées sur la face inférieure du bras d'acheminement de telle façon que les extrémités libres des éléments élastiques se trouvent au-dessus des bouts des ventouses afin de ne pas venir en contact avec le substrat retenu par les ventouses au cours de l'acheminement du substrat.

2. Dispositif d'acheminement de substrat selon la revendication 1, dans lequel les éléments élastiques sont des ressorts plats.

3. Dispositif d'acheminement de substrat selon la revendication 1, dans lequel les éléments élastiques sont des ressorts à boudin.

4. Dispositif d'acheminement de substrat selon l'une quelconque des revendications 1 à 3, dans lequel les éléments élastiques sont disposés entre des ventouses voisines.

5. Dispositif d'acheminement de substrat selon l'une quelconque des revendications 1 à 4, dans lequel les éléments élastiques sont montés sur des blocs de montage fixés à la face inférieure du bras d'acheminement.

6. Dispositif d'acheminement de substrat selon l'une quelconque des revendications 1 à 5, dans lequel les éléments élastiques sont disposés de façon à appuyer sur une surface du substrat au moment où le substrat est placé sur le support de travail.

7. Dispositif d'acheminement de substrat selon la revendication 6, dans lequel les éléments élastiques sont disposés de façon à appuyer sur une partie périphérique du substrat au moment où le substrat est placé sur le support de travail.
